# EUROPEAN PATENT APPLICATION

(11) **EP 4 491 288 A1**
(43) Date of publication of application: **15.01.2025**
(21) Application number: 24182523.1
(22) Date of filing: 17.06.2024
(51) Int. Cl.: B06B 1/02, B06B 1/06

(54) **MICROMACHINED ULTRASONIC TRANSDUCER DEVICE WITH HIGH QUALITY FACTOR**

(30) Priority: 10.07.2023 IT 202300014343
(71) Applicant: STMicroelectronics International N.V., 1228 Plan-les-Ouates, Geneva (CH)
(72) Inventor: SAVOIA, Alessandro Stuart, 00135 ROMA (IT); GIUSTI, Domenico, 20867 CAPONAGO (MB) (IT); PRELINI, Carlo Luigi, 20822 SEVESO (MB) (IT)
(74) Representative: Studio Torta S.p.A.

(57) **Abstract**

Micromachined ultrasonic transducer (320) wherein a die (321) including semiconductor material accommodates at least one ultrasonic cell (345). Each ultrasonic cell (345) includes a piezoelectric structure (431), a cavity (329), and a membrane region (330), vertically aligned with each other. The cavity (329) extends inside the die (321) and downwardly delimits the membrane region (330). The piezoelectric structure (431) is arranged on the membrane region (330) and has at least one annular-shaped piezoelectric region (231A). The micromachined ultrasonic transducer is configured to operate around the second axisymmetric vibration mode.

## Description

### Technical Field

The present invention relates to a micromachined ultrasonic transducer device with high quality factor.

### Background

As is known, ultrasonic transducers are devices capable of emitting and receiving acoustic waves (in particular, ultrasounds with a frequency comprised between 20 kHz and 100 MHz) in fluid (liquid or gaseous) and/or solid propagation media, by converting electromechanical, acoustic or light energy.

In particular, silicon Micromachined Ultrasonic Transducers (MUTs) have very small dimensions and are manufactured using silicon bulk micromachining and/or surface micromachining processes.

MUT devices comprise membranes capable of vibrating both when electrically excited, for the generation of acoustic waves transmitted to an external medium, and when they receive acoustic waves and generate corresponding electrical signals. They are therefore capable of forming transmitter-receiver systems.

In particular, in MUT devices, the vibrational operation of membranes exploits piezoelectric effects (piezoelectric MUTs, PMUTs) or electrostatic effects (capacitive MUTs, CMUTs).

The electroacoustic conversion efficiency of the emitted/received energy, the frequency response gain and bandwidth are the identifying parameters of the MUTs. They depend both on factors specific to the MUTs (such as geometry and materials of the transducers, which determine a mechanical impedance of the MUT) and by factors specific to the acoustic wave propagation media (such as the density of the propagation media and the velocity of the sound conveyed thereby, which determine an acoustic impedance thereof).

Micromachined ultrasonic transducers have been proposed for different applications, such as distance measurement and object and environment imaging, based on pulse echo detection, i.e. on the transmission of acoustic waves (e.g., of an ultrasonic pulse) and on the reception of ultrasonic echoes generated by the reflection and spread of acoustic waves in the environment.

Recently, the use of MUT transducers has also been proposed for wirelessly transferring energy to microsystems operating in non-directly contactable environments, for example to implantable bio-medical devices, or other devices which are arranged in the air (or in a non-accessible liquid medium) and cannot be powered by batteries having large dimensions.

In particular, implantable bio-medical devices use batteries having small dimensions, which therefore have a limited duration and need to be periodically replaced or recharged, which represents a difficulty in implanted or, in any case, in non-directly contactable systems.

To overcome this issue, the use of micromachined ultrasonic systems has already been proposed, to transfer power from an external transducer element (therefore operating as a transmitter) to an internal transducer element, associated with the implanted device (and therefore operating as a receiver), thanks to the small dimensions of MUT devices.

For example, in case of PMUTs, both the implantable transducer element and the transmitter comprise a piezoelectric structure overlying the vibrating membrane, thus forming a PMUT cell, or a pair of electrodes, one of which is arranged in contact with the membrane, mutually spaced, thus forming a CMUT cell.

These cells may be arranged side by side, thus forming a PMUT or CMUT cell matrix.

When used in devices implantable in the human body, ultrasonic transducers may be coated with biocompatible material.

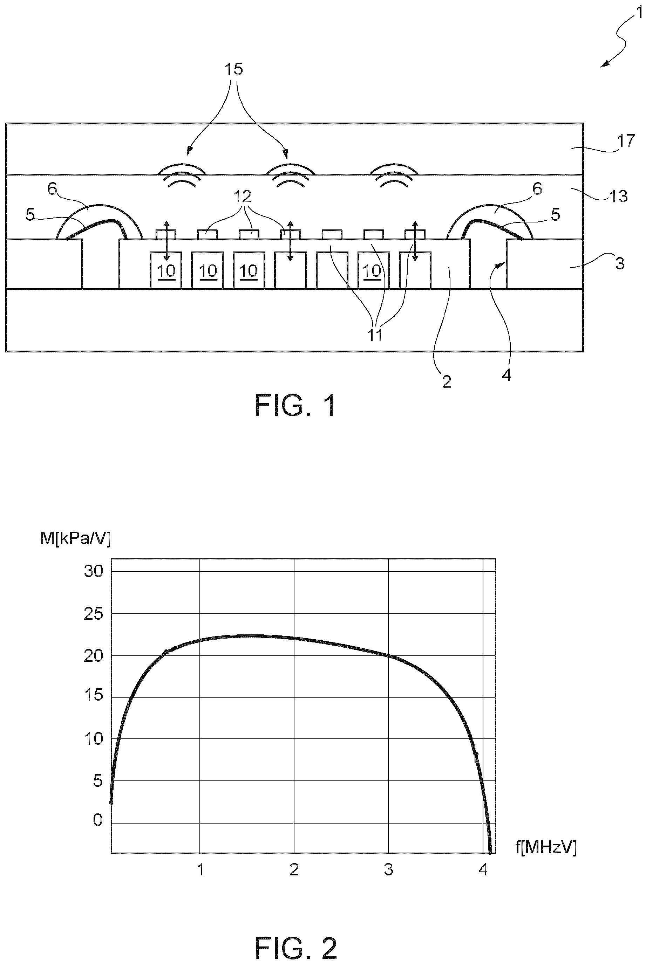

For example, Figure 1 shows the structure of a PMUT device 1 usable as a transmitter in an energy transfer system. However, the same structure may be used in case the PMUT device 1 operates as a receiver.

The PMUT device 1 comprises a substrate, for example of insulating material such as FR4, carrying a die 2 and a printed circuit 3. The printed circuit 3 has here a through opening 4 and the die 2 is arranged inside the through opening 4, at a distance from the printed circuit 3, and is connected thereto by wires 5, covered by insulating regions 6, for example of a resin such as glob top, which also fill the through opening 4, between the die 2 and the printed circuit 3.

The die 2, comprising semiconductor material, typically silicon, has a plurality of cavities 10, typically of cylindrical shape, having a corresponding plurality of membranes 11 extending thereon, formed by the die 2 and therefore generally of silicon (non-piezoelectric silicon) or dielectric material used in the semiconductor industry.

Above each membrane 11 a piezoelectric structure 12 is formed, shown schematically and typically formed by a pair of electrodes separated by a piezoelectric layer. The piezoelectric layer may be of any suitable material, such as lead-zirconate-titanate PZT deposited via PVD (Physical Vapor Deposition) or as sol-gel, aluminum nitride (AlN) and scandium-doped aluminum nitride (AlScN).

An elastomeric region 13, for example of silicone or polyurethane, covers the upper surface of the die 2, at the piezoelectric structures 12, as well as the insulating regions 6 and the printed circuit 3.

The elastomeric region 13 embeds the electrical structures (piezoelectric structures 12 and contacts on the die and on the printed circuit 3, not shown), protecting them. Furthermore, it has impedance similar to water and human tissue, ensuring good coupling.

In use, an alternating electric signal is applied to the piezoelectric structures 12, at a suitable frequency, causing vibration of the membranes 11 at this frequency and generation of ultrasonic waves (represented by 15 in Figure 1) which propagate in a medium (for example water or human tissue), indicated by 16 in Figure 1.

In general, micromachined ultrasonic systems vibrate in a flexural mode and work in broadband (see Figure 2), at a frequency in the range 1 MHz to 5 MHz, where they resonate with a high mechanical quality factor (Q) in air.

However, micromachined ultrasonic systems of the type shown in Figure 1 have low mechanical impedance when operating in a liquid propagation medium or a solid medium with impedance similar to water (for example, human tissue or a biocompatible soft material such as silicone or polyurethane); in these conditions, therefore, the mechanical quality factor Q is considerably reduced due to the damping effect of the acoustic load of the medium.

Furthermore, since the electromechanical coupling factor of a MUT transducer (i.e. the ratio between the amount of energy actually converted into mechanical energy and obtained electrical energy) is relatively low and most of the energy is used to charge and discharge the transducer electrical capacitance and is not transferred, the electrical impedance is mostly capacitive; therefore the phase angle is large and close to -90°, reducing the efficiency.

Consequently, to maximize the power transfer and improve both the transmission (TX) and reception (RX) conversion efficiency, electrical matching nets using inductors are usually used.

However, using inductors for electrical matching has several problems:
- The inductors are large and heavy, reducing the possibility of miniaturizing the system.
- The equivalent series resistance of the inductors and/or electrical interconnections of the MUT limits the efficiency.

The aim of the present invention is to overcome the problems of the prior art.

### Summary

According to the present invention, a micromachined ultrasonic transducer device and the manufacturing process thereof are provided, as defined in the attached claims.

### Brief Description of the Drawings

For a better understanding of the present invention, some embodiments thereof are now described, purely by way of non-limiting example, with reference to the attached drawings, wherein:
- Figure 1 is a cross-section of a known micromachined transducer;
- Figure 2 shows the TX sensitivity of the micromachined transducer of Figure 1;
- Figure 3 is a simplified cross-section of an embodiment of a piezoelectric micromachined transducer;
- Figure 4 is a top view of a portion of the micromachined transducer of Figure 3;
- Figure 5 is a simplified cross-section of another embodiment of the present piezoelectric micromachined transducer;
- Figure 6 is a top view of a portion of the micromachined transducer of Figure 5;
- Figure 7 is a simplified perspective view, partially broken away, of a cell of the micromachined transducer of Figures 5 and 6, during operation;
- Figure 8 is a simplified perspective view, partially broken away, of a cell of a different embodiment of the micromachined transducer, during operation;
- Figure 9 is a simplified cross-section of yet another embodiment of the present micromachined transducer;
- Figure 10 is a top view of a portion of the micromachined transducer of Figure 9;
- Figure 11 is a cross-section of a multilayer piezoelectric structure usable in the micromachined transducer of Figures 3-10;
- Figure 12 is a cross-section of a micromachined transducer having the multilayer piezoelectric structure of Figure 11 and applicable to the solutions of Figures 5-10;
- Figure 13A is a simplified cross-section of a different embodiment of the present micromachined transducer;
- Figure 13B is a simplified cross-section of a different embodiment of the present micromachined transducer;
- Figures 14A-14C are comparative plots showing the trend of electrical quantities of the micromachined transducer of Figure 1 and of the micromachined transducer of Figures 3 and 4;
- Figures 15A-15C are comparative plots showing the trend of electrical quantities of the micromachined transducer of Figure 1 and of the micromachined transducer of Figures 5 and 6;
- Figures 16A-16C are comparative plots showing the trend of electrical quantities of the micromachined transducer of Figure 1 and of the transducer of Figures 9 and 10, with a piezoelectric region formed using sol-gel technology;
- Figures 17A-17C are comparative plots showing the trend of electrical quantities of the micromachined transducer of Figure 1 and of the transducer of Figures 9 and 10, with a piezoelectric region formed by PVD deposition;
- Figures 18A-18E show cross-sections of a wafer for a micromachined piezoelectric ultrasonic transducer, in successive manufacturing steps; and
- Figures 19A-19F show cross-sections of a wafer for a micromachined capacitive ultrasonic transducer, in successive manufacturing steps.

### Description of Embodiments

The following description refers to the arrangement shown; consequently, expressions such as "above", "below", "upper", "lower", "right", "left" relate to the accompanying Figures and should not be interpreted in a limiting manner. Furthermore, the vertical alignment indications used refer to the usual conventions in the semiconductor field.

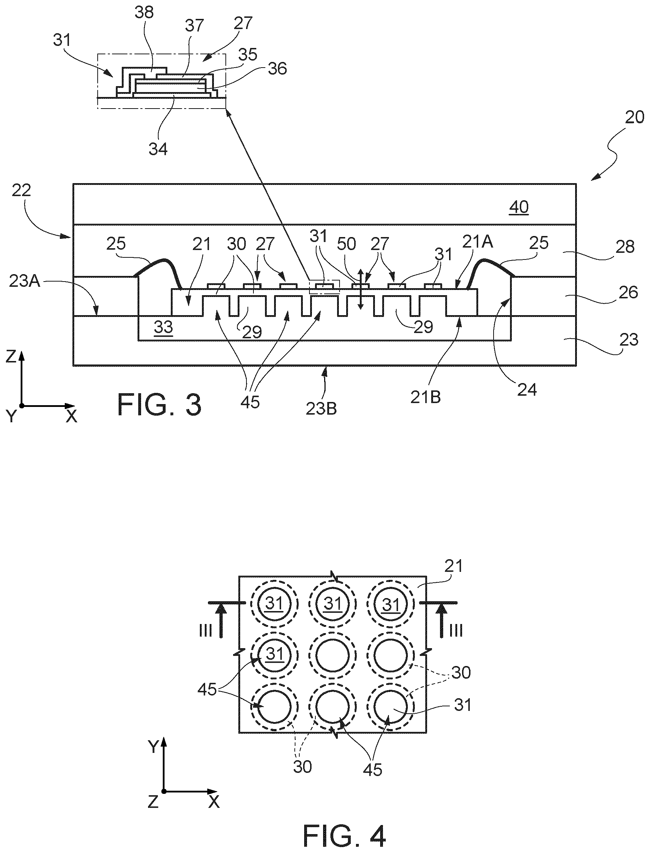

Figures 3 and 4 show a PMUT device 20, usable both as a transmitter and as a receiver of an energy transfer system.

The PMUT device 20 comprises a die 21 and a support structure 22.

The support structure 22 comprises a support element 23, a printed circuit board 26 and a soft layer 28.

The printed circuit board 26 is formed by insulating material, such as FR4, and is provided with a through opening 24 accommodating the die 21 at a distance from the printed circuit board 26.

The printed circuit board 26 may form electrical connections (not shown) accessible from the outside (for the PMUT device 20 formed as a transmitter).

Alternatively, the printed circuit board 26 may accommodate or carry a power supply element.

Furthermore, the printed circuit board 26 may carry an electromedical device (not shown) intended to be implanted and/or electrical connections for coupling the die 21 to the electromedical device, for the PMUT device 20 formed as a receiver.

The printed circuit board 26 and the die 21 are here electrically connected through wires 25 and contact pads not shown.

The die 21, typically of silicon, has a first main surface 21A and a second main surface 21B, opposite to the first main surface 21A. The first and the second main surfaces 21A, 21B extend parallel to a main extension plane of the PMUT device 20, parallel to a plane XY of a Cartesian reference system XYZ.

A plurality of cavities 29 extend from the second main surface 21B towards the first main surface 21A and downwardly delimit respective membranes 30, formed by the same die 21. The cavities 29 typically have a cylindrical shape, with axis parallel to a vertical axis Z of the Cartesian reference system XYZ.

A respective piezoelectric structure 31 extends above each membrane 30. Each membrane 30 and the respective piezoelectric structure 31 form a vibrating structure 27.

The piezoelectric structure 31 is shown in the enlarged detail of Figure 3 and is formed by a stack including a pair of electrodes (lower electrode 34 and upper electrode 35) separated by a piezoelectric region 36.

For example, the electrodes 34 and 35 are of platinum and the piezoelectric region 36 is of any suitable material, such as lead-zirconate-titanate PZT deposited via PVD (Physical Vapor Deposition) or as sol-gel, aluminum nitride (AlN) and scandium-doped aluminum nitride (AlScN).

The piezoelectric structure 31 is covered by a passivation layer 37, interrupted to connect the electrodes 34, 35 to metal connection lines (a visible connection line, connection line 38, coupled to the upper electrode 35).

Each membrane 30, with the relative piezoelectric structure 31 and cavity 29, defines an ultrasonic cell or ultrasonic pixel 45 of the PMUT device 20; in particular, the PMUT device 20 comprises a plurality of ultrasonic cells 45, as visible in the top view of Figure 4, showing a portion of the main surface 21A of the die 21 and highlighting the matrix arrangement of the ultrasonic cells 45.

As noted, here, the piezoelectric structures 31, and in particular the piezoelectric regions 36, have a disc shape.

The piezoelectric regions 36 may have a thickness comprised between 1 and 50 pm, for example 2 µm, and a diameter comprised between 30 and 800 pm, for example of 300 µm.

The cavities 29 (and therefore the membranes 30) have a larger diameter than the piezoelectric structures 31, for example larger by 40-50%.

In Figure 3, the support element 23 has an upper surface 23A, facing the die 21, which is not planar, but has a recess 33 that faces the same die 21, so as to define a gap (indicated with the same reference number 33) which allows the die 21 to freely vibrate.

In practice, the support element 23 here forms a lower wall 23B spaced from the die 21 and closing the gap 33 with respect to the outside.

The recess 33 has an area (in top view) greater than the die 21, for example here approximately equal to that of the through opening 24, so as to avoid clamping of the die 21 on its second main surface 21B (die downwardly unclamped) .

Alternatively, the recess 33 may be a through recess.

The recess 33 may be filled with soft material, for example a same silicone as the soft layer 28 (see below) or a different, softer, silicone, for example a sealing silicone commonly available on the market.

The support element 23 is for example of monocrystalline silicon, but may be formed by any material compatible with the application (in particular, when it operates as a receiver intended to be implanted in human tissue, of biocompatible material) so as to have suitable mechanical strength and provide stability to the PMUT device 20.

The soft layer 28, an electrically insulating layer, covers the first main surface 21B of the die 21 and the upper surface of the printed circuit board 26, by adhering thereto, incorporates the wires 25 and keeps the die 21 suspended above the recess 33.

To this end, the soft layer 28 is of a material with an adhesiveness such as to securely hold the die 21 over time, flexibility such as to allow for an unclamped vibration of the membranes 30 during use and specific acoustic impedance (product of density and velocity of the longitudinal elastic waves, here of ultrasonic waves) similar to that of the medium in which it operates (schematically represented in Figure 3 by a layer 40).

Possibly, an adhesion promoting layer may be arranged between the soft layer 28 and the die 21, for example based on silane, such as 3-aminopropyltriethoxyslane (APTES) and 3-glycidoxypropyltrimethoxysilane (GPTMS).

For example, the soft layer 28 may be an elastomeric material, such as silicone or polyurethane, having an acoustic impedance proximate to that of human tissue, ensuring good coupling in case of applications for implantable medical devices. For example, the soft layer 28 may have a specific acoustic impedance comprised between 1 and 2 MRayl, a density comprised between 0.8 and 2 g/cm³ and an ultrasonic wave velocity comprised between 1000 and 2000 m/s.

In use, the supply of a voltage between the electrodes 34, 35 of the piezoelectric structure 31 or the reception of an acoustic wave by the membranes 30 determines the vibration thereof with a simple alternate movement upwards (towards the soft layer 28) and downwards (towards the inside of the cavities 29), in accordance with a first axisymmetric vibration mode, as shown by the double arrow 50 in Figure 3.

The suspension of the die 21 by the soft layer 28, in instead of through a substrate downwardly attached to the die, on its second main surface 21B and/or on the sides, and the elimination of the glob-top regions allow the die to vibrate more freely, with a greater displacement, thus improving the quality factor Q.

Furthermore, the presence of air on the back of the die 21 allows the quality factor Q of the PMUT device 20 to be further improved, with a better and more efficient energy transfer.

The die 21 may be formed with a very small thickness, for example of 100-200 µm or even lower, down to 40-50 µm, in case of use in a non-critical environment, to avoid breakdowns, reducing the overall thickness of the PMUT device 20.

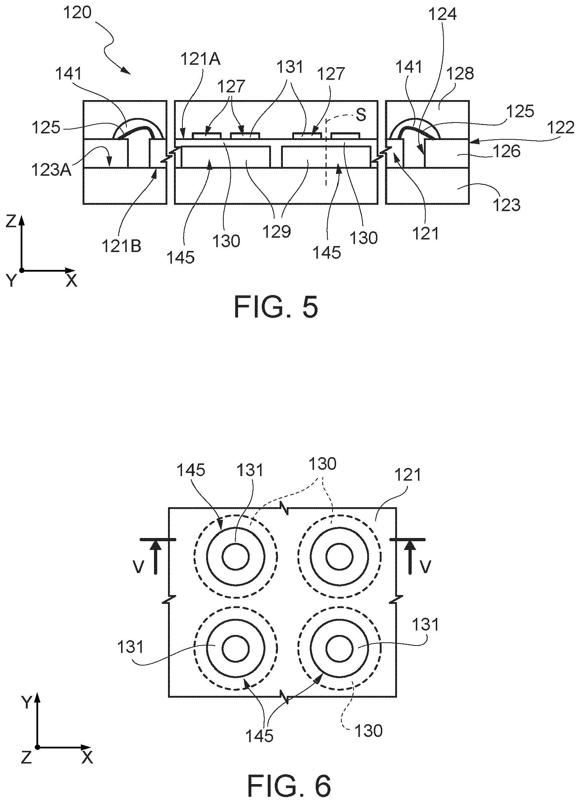

Figures 5 and 6 show a PMUT device 120 usable both as a transmitter and as a receiver of an energy transfer system.

The PMUT device 120 of Figures 5 and 6 has a general structure similar to the PMUT device 20 of Figures 3 and 4; consequently, it is described only briefly for the common parts. In general, parts corresponding to similar parts of the PMUT device 20 of Figures 3 and 4 are indicated with reference numbers increased by 100.

In particular, the PMUT device 120 of Figures 5 and 6 comprises a die 121 and a support structure 122.

The support structure 122 here comprises a support element 123, a printed circuit board 126 and a soft layer 128.

The die 121 has a first main surface 121A and a second main surface 121B, opposite to the first main surface 121A.

The die 121 also has a plurality of cavities 129, extending from the second main surface 121B to the inside of the die 121 and delimiting respective membranes 130 downwardly.

The support element 123 here has an upper surface 123A, arranged facing the die 121, which is planar and is bonded, for example glued, to the second main surface 121B of the die 121, downwardly closing the cavities 129.

The printed circuit board 126 has also here a through opening 124 having the die 121 arranged therein.

The die 121 is electrically coupled to the printed circuit board 126 through wires 125, embedded in insulating regions 141, for example of a resin such as glob top, which also fill the through opening 124, between the die 121 and the printed circuit board 126 and which otherwise are covered by a soft layer 128.

The soft layer 128, an electrically insulating layer, covers and adheres to the upper side 121B of the die 121 and to the printed circuit board 126, incorporating the insulating regions 141, as indicated above.

Piezoelectric structures 131 extend on respective membranes 130 and form respective vibrating structures 127 therewith.

The piezoelectric structures 131 are formed also here by a stack including a pair of electrodes 34, 35 and a piezoelectric region 36, not shown in detail and similar to the stack shown in the enlarged detail of Figure 3.

In Figures 5 and 6, the piezoelectric structures 131 have an annular shape, as visible in particular in the top view of Figure 6, relating to a portion of the first main surface 121A of the die 121.

The cavities 129 have a vertical central axis S extending parallel to the vertical axis Z; in particular, they have a cylindrical shape, and the piezoelectric structures 131 are each concentric with the respective cavity 129.

The piezoelectric structures 131 may have a thickness comprised between 1 and 50 pm, for example of 2 pm, an external diameter comprised between 30 and 800 pm, for example of 350 pm, and an internal diameter for example comprised between 10 µm and 780 pm, for example of 150 µm.

Forming the piezoelectric structures 131 with an annular shape allows the PMUT device 120 to operate the second axisymmetric vibration mode.

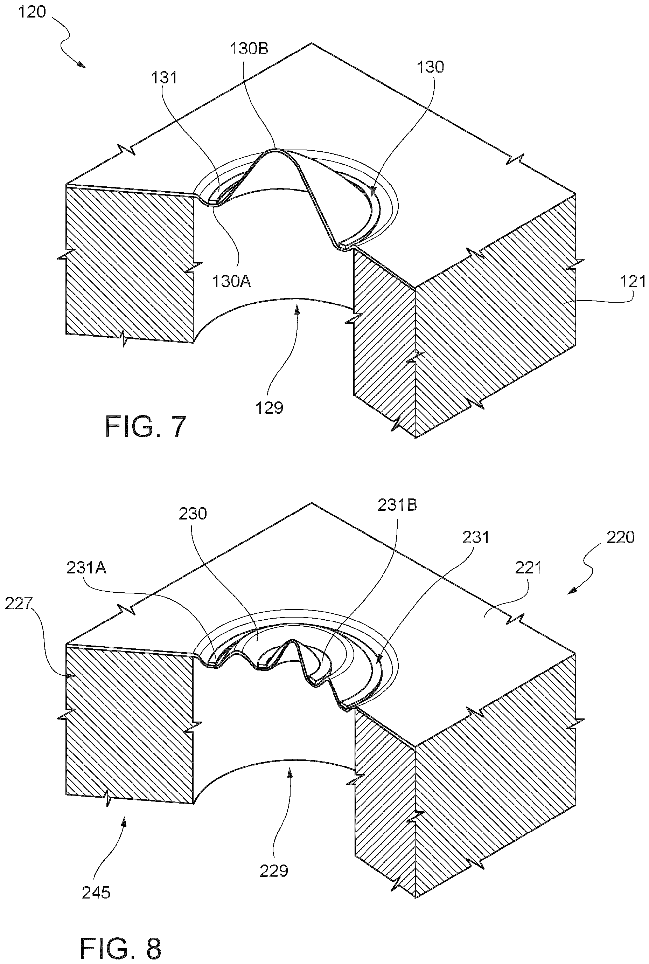

In particular, here, the annular shape of the piezoelectric structures 131 causes the membranes 130 to move in the manner shown in Figure 7.

In particular, as visible in Figure 7, in each membrane 130, the portion of the membrane surface underlying the respective piezoelectric structure 131 (indicated as an annular portion 131A) surrounds a central portion 131B which, in use, moves with a sinusoidal motion opposite to the annular portion 231A.

According to a different embodiment, each piezoelectric structure may be made of a plurality of annular structures, causing the micromachined transducer to work in an even greater vibrational mode (e.g., a third or fourth mode), thus increasing the natural frequency of the micromachined transducer.

For example, Figure 8 shows a PMUT device 220 having an ultrasonic cell 245 formed in a die 221 having a cavity 229 delimiting a membrane 230 in the die 221.

In Figure 8, the piezoelectric structure (here indicated by 231 and forming, together with the membrane 230, a vibrating structure 227), comprises two rings 231A, 231B, concentric with each other, which cause, in use, a vibration of the underlying portion of the membrane 230 in phase opposition with respect to the adjacent portions.

In one embodiment, the PMUT device 220 has a natural frequency of nearly 3 MHz.

In general, by modifying the position and the number of the rings of the piezoelectric structures, the PMUT device may be designed so that it has a resonance frequency of the desired value.

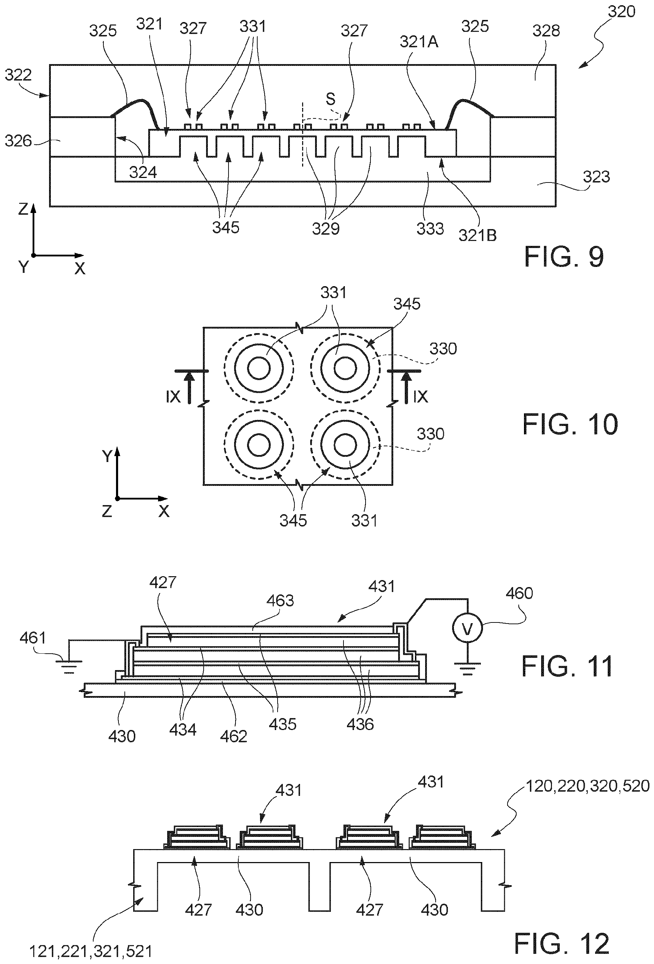

Figures 9 and 10 show a PMUT device 320 usable both as a transmitter and as a receiver in an energy transfer system.

The PMUT device 320 of Figures 9, 10 has a general structure similar to the PMUT device 20 of Figures 3 and 4; consequently, it is described only briefly hereinbelow for the common parts. In general, parts of the PMUT device 320 corresponding to similar parts of the PMUT device 20 of Figures 3 and 4 are indicated with reference numbers increased by 300.

In particular, the PMUT device 320 of Figures 9, 10 comprises a die 321 and a support structure 322.

The support structure 322 here comprises a support element 323, a printed circuit board 326 and a soft layer 328.

The die 321 has a first main surface 321A and a second main surface 321B, opposite to the first main surface 121A.

The die 321 also has a plurality of cavities 329, extending from the second main surface 321B to the inside of the die 321 and delimiting respective membranes 330 downwardly.

Here, the support element 323 has an upper surface 323A, arranged facing the die 321, which is not planar and has a recess 333 arranged facing the die 321, similarly to the PMUT device 20 of Figure 3.

The cavity 329 of each ultrasonic cell 345 is therefore overlying and directly connected to the recess 333 which, as in the PMUT device 20 of Figure 3, may contain air or a soft gel.

In Figure 9, the die 321 is inserted in a through opening 324 of the printed circuit board 326 and suspended above the recess 333 by the soft layer 328, which covers and adheres to the first main surface of the die 321 and to the upper surface of the printed circuit board 326, incorporating the wires 325.

The soft layer 328 may be of the same material as the soft layer 28 of Figure 3.

In the PMUT device 320 of Figures 9, 10, the piezoelectric structures, here indicated by 331, forming vibrating structures 327 with the respective membranes 230, have an annular shape (see also the top view of Figure 10) and are arranged concentrically with the respective membranes 330, similarly to the PMUT device 120 of Figure 5.

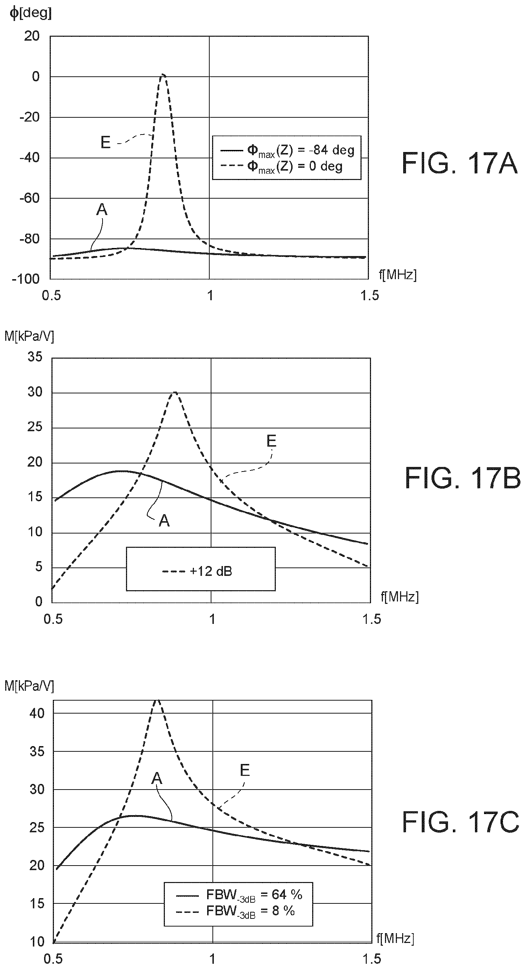

In practice, the PMUT device 320 combines the characteristics of the devices 120 and 220 of Figures 3 and 5, allowing a synergistic effect, with considerable improvement of the quality factor and of the impedance phase at resonance, as discussed further below, with reference to Figures 17A-17C.

Figure 11 shows one of a vibrating structure 427. The piezoelectric structure 431 is of multilayer type and is usable in any embodiment of the PMUT device.

In detail, the piezoelectric structure 431 comprises a stack of layers including lower electrodes 434 (here, two), upper electrodes 435 (here, two), and piezoelectric regions 436 (here, three). The lower electrodes 434 and the upper electrodes 435 are alternated with each other and each piezoelectric region 436 is arranged between a lower electrode 434 and an upper electrode 435.

The upper electrodes 435 are electrically connected to each other and to a voltage generator 460; the lower electrodes 434 are electrically connected to each other and to ground (461).

For example, the electrodes 434 and 435 are of platinum and the piezoelectric regions 436 are of one of the materials indicated above for the electrodes 34 and 35.

In the case of piezoelectric regions 436 of ScAlN, they may have a thickness of 1 µm.

An insulating layer 462 extends between the piezoelectric structure 431 and the membrane, here indicated by 430; a passivation layer 463 covers the piezoelectric structure 431 and is open at contacts.

The piezoelectric structure 431 may have a discoidal shape (in top view), and may be used in the PMUT device 21 of Figure 3, instead of the piezoelectric structure 31.

Alternatively, it may have an annular shape (in top view), with Figure 11 showing the cross-section of a portion, and may be used in the PMUT device 121, 221 or 321 of Figure 5, 8 or 9, instead of the piezoelectric structure 131, 231, 331. Figure 12 shows, for example, a PMUT device 120, 220, 320 having the piezoelectric structure 431 of multilayer type.

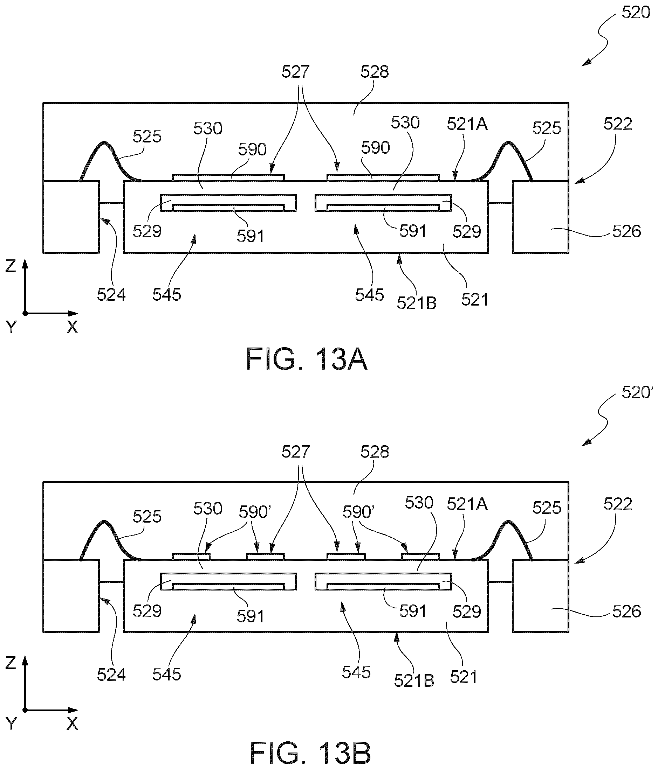

Figure 13A shows a capacitive ultrasonic device, CMUT device 520, usable both as a transmitter and as a receiver of an energy transfer system.

The CMUT device 520 comprises a die 521 and a support structure 522.

The support structure 522 here comprises a printed circuit board 526 and a soft layer 528.

The printed circuit board 526 and the soft layer 528 may be formed as described above for the PMUT device 20.

In particular, the die 521 is inserted in a through opening 524 of the printed circuit board 326 and the printed circuit board 526 may be electrically connected to the die 521 through wires 525.

The die 521, comprising a silicon substrate and insulating layers not shown, has a first main surface 521A and a second main surface 521B, opposite to the first main surface 521A.

The die 521 forms a plurality of ultrasonic cells 545 including, each, a cavity 529, a membrane 530, a first electrode 590 and a second electrode 591.

The membrane 530 and the electrodes 590, 591 of each ultrasonic cell 545 form respective vibrating structures 527.

Each cavity 529 typically has a cylindrical shape, extends below the first main surface 521A of the die 521 and delimits a respective membrane 530 downwardly, formed by the same die 521.

Each first electrode 590 here extends above a respective membrane 530.

Each second electrode 591 is arranged in the cavity 529, on the side of the respective cavity 529 opposite to the membrane 530 (arranged facing the second surface 521B of the die 521) . Each second electrode 591 is vertically aligned with a respective first electrode 590 and capacitively coupled thereto, with the air in the respective cavity 529 and any dielectric passivation layers (not shown) operating as a dielectric.

The electrodes 590, 591 may be formed by deposited and patterned metal layers or by other conductive material, for example doped mono- or polycrystalline silicon.

The soft layer 528 is also here an electrically insulating layer, covers the first main surface 521A of the die 521 and the upper surface of the printed circuit board 526, incorporating the wires 525 and supporting the die 521, suspended below the soft layer 528.

The soft layer 528 may be formed as already indicated for the PMUT devices 20, 120 and 320; in particular, it is of a material having acoustic impedance and sound transmission characteristics (propagation velocity) similar to those of the medium in which the CMUT device 520 is expected to operate, adhesiveness such as to securely hold the die 521 over time, and flexibility such as to allow for unclamped vibration of the membranes 530 during use.

Suspending the die 521 by the soft layer 528, instead of through a substrate downwardly attached to the die 521, allows a considerable improvement of the quality factor.

Figure 13B shows a capacitive ultrasonic device 520' similar to the CMUT device 520, but having electrodes 590' of annular shape. In case, also second electrodes 591 may be annular.

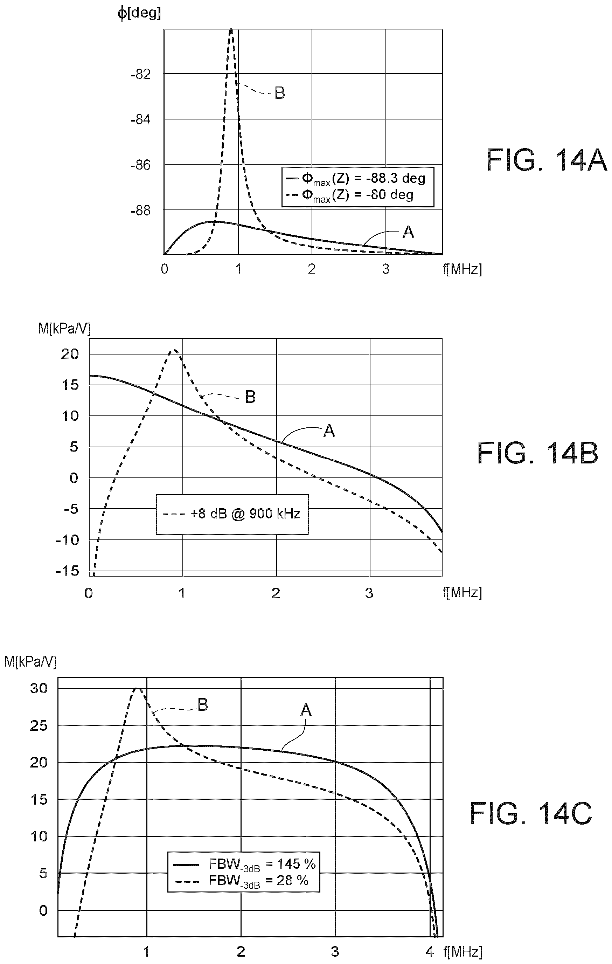

Figures 14A, 14B and 14C show simulations, respectively, of the electrical impedance phase, the open-circuit RX sensitivity magnitude and the TX sensitivity magnitude for the PMUT device 1 of Figure 1 (curves A) and the PMUT device 20 of Figure 3 (curves B), for a piezoelectric structure of sol-gel.

In particular, the simulations have been carried out for a PMUT device 1 of Figure 1 having the die 2 with a thickness of 400 pm, piezoelectric structure 12 with a diameter of 140 µm and a thickness of 2 µm and for a transducer 20 of Figure 3 having the die 21 with a thickness of 200 pm, disc-shaped piezoelectric structure 12 with a diameter of 140 µm and a thickness of 2 µm.

As noted, eliminating the clamping of the die 21 and forming the support of the die 21 by the soft layer 28 (eliminating the insulating regions 6 of glob top of the PMUT device 1) allow the die 21 of Figure 3 to have a greater freedom of displacement; therefore, the mechanical quality factor Q increases and the reactance to resonance reduces (reducing the impedance phase angle).

In the simulations shown, in which the die 21 also has small thickness, greater efficiency is obtained thanks to the improvement of the phase angle of more than 8° and both RX (Figure 14B) and TX (Figure 14C) sensitivity peaks at about 900 kHz. In particular, curve B of Figure 14B shows an improvement of 8 dB with respect to curve A, and curve B of Figure 14C shows a 3dB fractional bandwidth (FBW_{-3dB}) lower than one fifth of curve A.

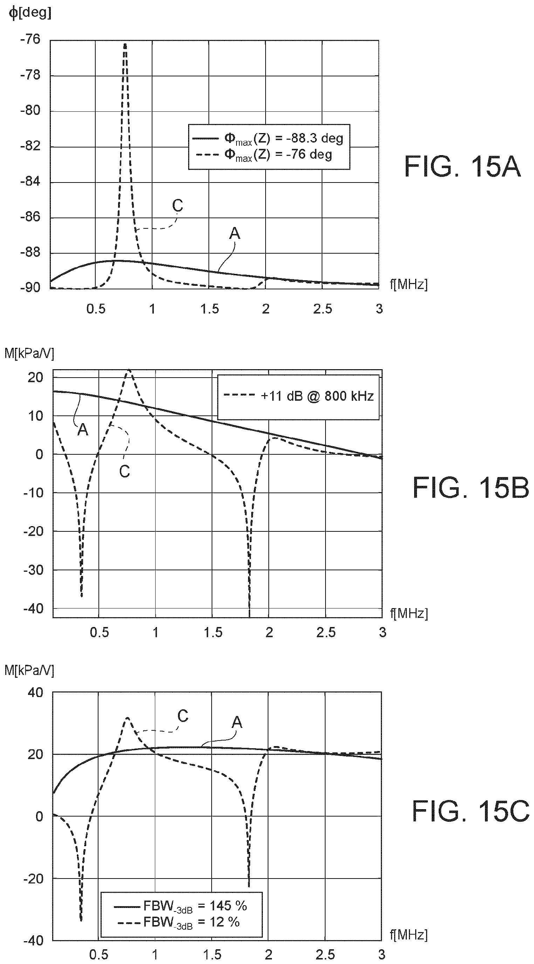

Figures 15A, 15B and 15C show similar simulations of the electrical impedance phase, the open-circuit RX sensitivity magnitude and the TX sensitivity magnitude for the PMUT device 1 of Figure 1 (curves A) and for the PMUT device 120 of Figure 5 (curves C), for a piezoelectric structure of sol-gel.

In particular, Figures 15A, 15B e 15C refer to a PMUT device 120 with a piezoelectric structure 131 having annular shape, having external diameter of 350 µm and internal diameter of 150 µm.

As noted, forming a piezoelectric structure 131 having annular shape allows the PMUT device 120 to improve the phase angle (less losses) of more than 12°, and both RX (Figure 15B) and TX (Figure 15C) sensitivity peaks at about 800 kHz. In particular, curve B of Figure 14B shows an improvement of 11dB with respect to curve A, and curve B of Figure 14C shows a 3dB fractional bandwidth (FBW_{-3dB}) of less than one-tenth of curve A.

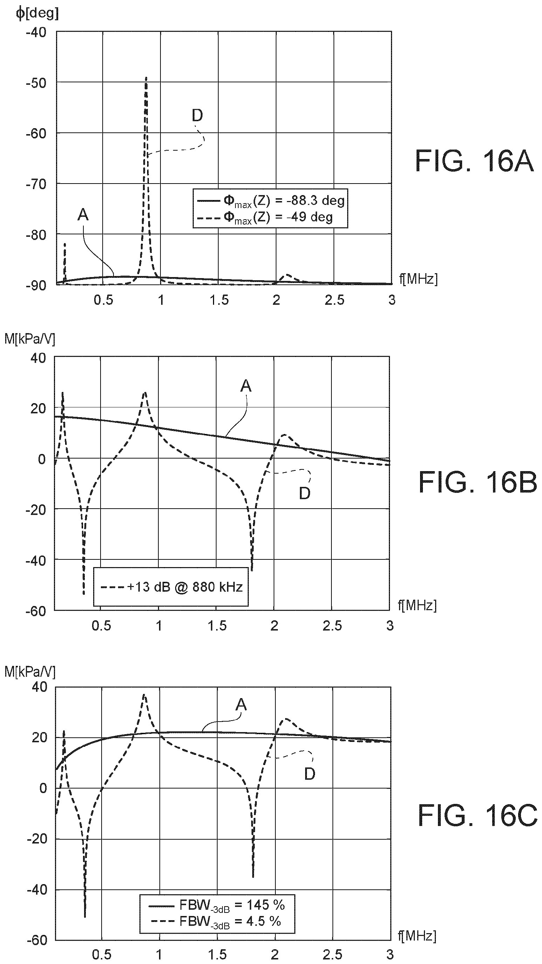

Figures 16A, 16B and 16C show similar simulations of the electrical impedance phase, the open-circuit RX sensitivity magnitude and the TX sensitivity magnitude for the PMUT device 1 of Figure 1 (curves A) and for the PMUT device 320 of Figure 9 (curves D), for a piezoelectric structure of sol-gel.

In particular, Figures 16A, 16B e 16C refer to a PMUT device 220 with an unclamped die 321 and an annular-shaped piezoelectric structure 331, having an external diameter of 350 µm and an internal diameter of 150 µm.

As noted, the combination of a soft suspension of the die 321 and the formation of the piezoelectric structure 331 of annular shape allows the PMUT device 320 to obtain an improvement in the phase angle of more than 39°, and both RX (Figure 16B) and TX (Figure 16C) sensitivity peaks at about 880 kHz. In particular, curve D of Figure 16B shows an improvement of 13 dB with respect to curve A, and curve D of Figure 14C shows a 3dB fractional bandwidth (FBW_{-3dB}) of nearly two orders of magnitude lower than curve A.

Figures 17A, 17B and 17C show similar simulations of the electrical impedance phase, the open-circuit RX sensitivity magnitude and the TX sensitivity magnitude for the PMUT device 1 of Figure 1 (curves A) and for the PMUT device 320 of Figure 9 (curves E), for a piezoelectric structure of plasma-deposited PZT (PVD PZT).

In particular, Figures 17A, 17B e 17C refer to a PMUT device 320 with an unclamped die 321 and an annular-shaped piezoelectric structure 331, having an external diameter of 350 µm and an internal diameter of 150 µm.

As noted, forming the piezoelectric region by PVD, instead of as sol-gel, allows the PMUT device 320 to obtain a very high improvement in the phase angle which becomes equal to about 0°, and sensitivity peaks higher than those of Figures 16B and 16C.

In this manner, in the PMUT device 320 simulated in Figures 16A-16C, the electrical impedance is purely resistive, allowing a perfect theoretical matching with a resistive medium/load.

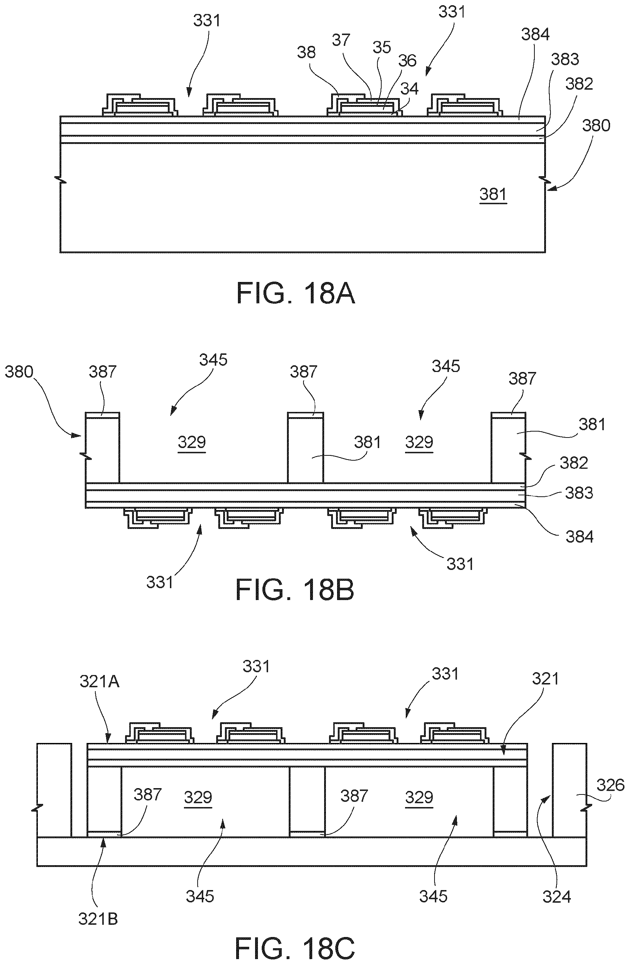

The PMUT device 320 of Figure 9 may be formed as shown in Figures 18A-18E, in which, for the sake of simplicity, the non-defined layers and structures, where useful for understanding, are indicated with the same reference numbers as in Figures 9 and 10.

In detail, Figure 18A shows a wafer 380 comprising a substrate 381. The substrate 381 may be of semiconductor material, such as monocrystalline silicon, and have a thickness of 500 µm.

Above the substrate 381 there have already been formed a first dielectric layer 382, for example by depositing TEOS (TetraEthylOrthoSilicate) with a thickness of 1 µm; a structural layer 383, for example a silicon layer epitaxially grown, with a thickness of 4 pm; and a second dielectric layer 384, for example by depositing TEOS, with a thickness of 5 µm.

The piezoelectric structures 331, of annular shape, have already been formed above the second dielectric layer 384. For example, the piezoelectric structures 331 are formed by depositing, in sequence, a first platinum electrode layer, a PZT piezoelectric layer (as sol-gel or by PVD), a second electrode layer, for example of TiW, and a passivation layer, for example of undoped silicate-based glass (USG) having a thickness of 0.5um; patterning the deposited layers; depositing and patterning a metal layer, thus forming the lower electrode 334, the piezoelectric region 336, the upper electrode 335, the passivation layer 337 and the metal connection lines (connection line 338 is visible here).

In Figure 18B, the wafer 380 is thinned, flipped over, an insulating layer, for example of TEOS, is deposited and patterned, forming a hard mask 387 and, using the hard mask 387, the substrate 381 is etched, for example by dry etching, stopping on the first dielectric layer 382 and forming the cavities 329.

In Figure 18C, the wafer 380 is diced, to obtain a plurality of dice 321 (one visible); and each die 321 is inserted into a respective through opening 324 of a printed circuit board 326.

In particular, in this step, the printed circuit board 326 is attached to an adhesive tape 388, for example of PVC (polyvinyl chloride), polyolefin, or polyethylene-based coating material, through the portions of the hard mask 387. In particular, the portions of the hard mask 387 are glued to the adhesive tape 388 by an ultraviolet or thermal treatment.

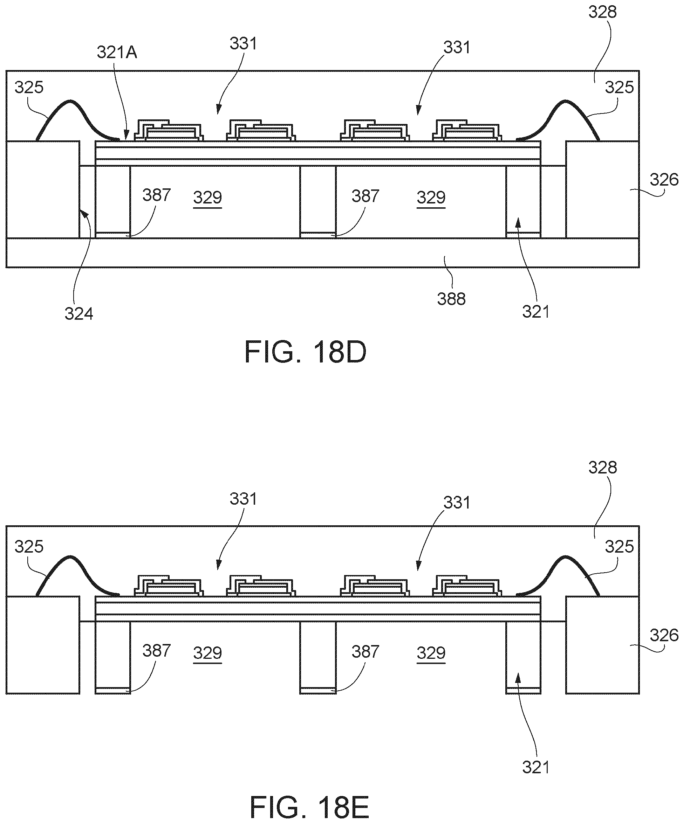

In Figure 18D, the wires 325 are bonded between contact pads (not shown) arranged on the first main surface 321A of the die 321 and similar contact pads (not shown) on the upper surface of the printed circuit board 326.

Furthermore, the soft layer 328 is formed, for example deposited by dispensing.

Possibly the printed circuit board 326 is cut and then the adhesive tape 388 is removed, by an ultraviolet treatment, obtaining the structure of Figure 18E.

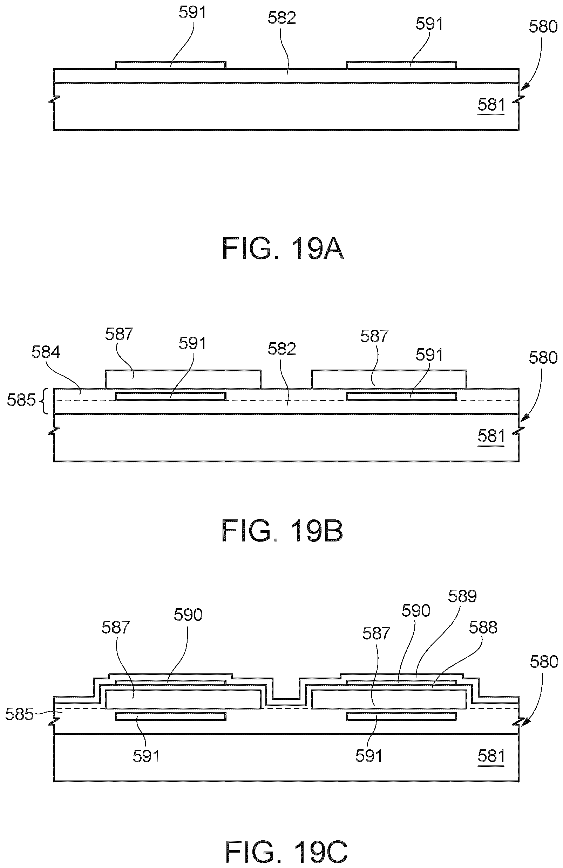

The CMUT device 520 of Figure 13 may be formed as shown in Figures 19A-19F, wherein, for the sake of simplicity, the layers and the non-defined structures, where useful for understanding, are indicated with the same reference numbers as in Figures 9 and 10.

In detail, Figure 19A shows a wafer 580 comprising a substrate 581. The substrate 581 may be of semiconductor material, such as monocrystalline silicon, and have a thickness of 500 µm.

A first dielectric layer 582, for example of thermally grown or deposited silicon oxide, having a thickness of 2 pm, extends above the substrate 581; the second electrodes 591 extend on the first dielectric layer 582, formed, for example, by depositing and defining a metal layer, such as an aluminum-based alloy.

In Figure 19B a second dielectric layer 584, for example of silicon oxide with a thickness of 0.2 µm, is deposited on the second electrodes 591 and on the first dielectric layer 582, where exposed and where it forms, together with the first dielectric layer 582, an overall dielectric layer 585.

Sacrificial regions 587, for example of metal such as an aluminum-based alloy, are formed above the second dielectric layer 584, vertically overlying the second electrodes 591. The sacrificial regions 587, formed for example by depositing and defining a metal layer such as an aluminum-based alloy, have a thickness equal to the depth of the cavities 529 of Figure 13, for example of 0.3 µm.

In Figure 19C a third dielectric layer 588, for example of silicon oxide with a thickness of 0.2 µm, is deposited on the sacrificial regions 587 and on the overall dielectric layer 585, where uncovered, increasing its thickness. The resulting layer is again referred to as overall dielectric layer 585, for the sake of simplicity.

Then, the first electrodes 590 are formed above the third dielectric layer 588, vertically overlying the sacrificial regions 587. The first electrodes 590 have a smaller size (area) than the sacrificial regions 587, typically equal to the second electrodes 591. For example, the first electrodes 590 are formed by depositing and defining a metal layer, such as an aluminum-based alloy.

Subsequently, a membrane layer 589 is formed above the first electrodes 590 and the overall dielectric layer 585, where uncovered.

The membrane layer 589 is for example of silicon nitride (Si₃N₄) with a thickness of 2 µm.

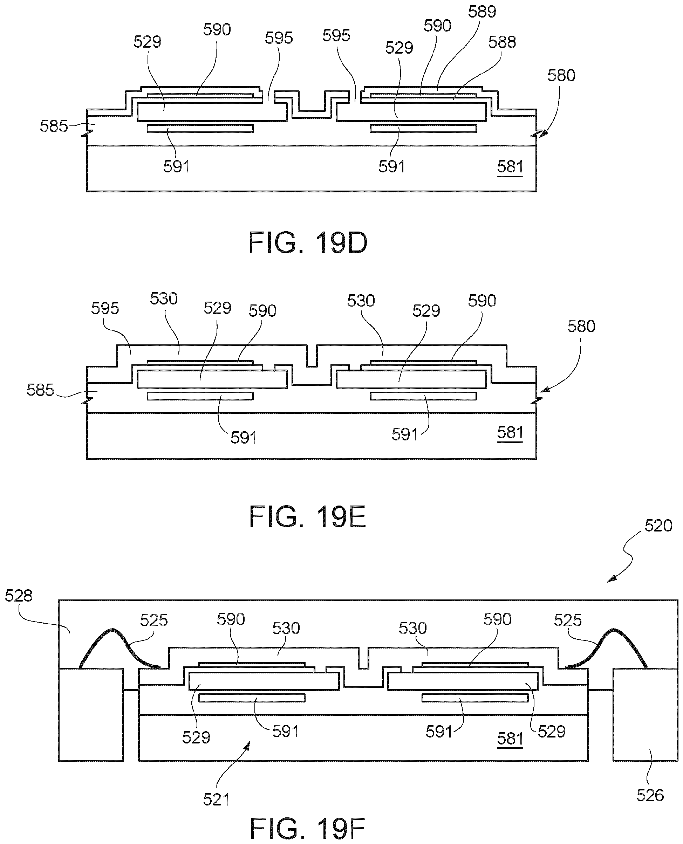

In Figure 19D, the membrane layer 589 and the dielectric layer 588 are etched and selectively removed over the sacrificial regions 587, forming openings 595 which reach the same sacrificial regions 587; then the sacrificial regions 587 are removed through the openings 595, such as by a wet etching. The cavities 529 are thus formed.

In Figure 19E, the membrane layer 588 is increased by material deposition. For example, the same material used in the step of Figure 19C, here silicon nitride, is deposited, closing the openings 595 and forming, above the first electrodes 590, the membranes 530 of Figure 13.

Then, steps similar to those already described with reference to Figures 18C-18E follow to obtain the device 520 of Figure 19F; in particular the wafer 580 may be thinned (for example, down to 200 µm); is diced (to obtain a plurality of dice 521, one visible); and each die 521 is inserted into a respective printed circuit board 526.

Here again, the printed circuit board 526 may be attached to a temporary adhesive tape; the wires 525 are bonded; and the soft layer 528 is formed.

After the possible removal of the adhesive tape (not shown) the CMUT device 520 of Figure 19F is obtained.

Consequently, the MUT device here described allows a considerable increase in the quality factor and therefore in the obtainable energy transfer efficiency, using common process steps in the manufacture of micromachined semiconductor devices, and therefore at a low cost.

Finally, it is clear that modifications and variations may be made to the MUT device and the manufacturing process thereof described and illustrated herein without thereby departing from the scope of the present invention, as defined in the attached claims. For example, the different embodiments described may be combined so as to provide further solutions.

For example, as shown in Figure 13B, the electrodes 591, 592 may have an annular shape. In this case, the CMUT device 520', being capacitive, is DC biased so that it may generate a reception electric signal. In the particular case of implanted devices, wherein the external bias, applied for example through a DC voltage generator, is impractical, the CMUT device 520 may be pre-biased by applying a voltage such as to inject and trap charges inside the dielectric passivation layers that surround the electrodes.

Furthermore, the multilayer structure of the piezoelectric regions, shown in Figures 11, 12, may be used in all PMUT devices 20, 120, 220, 320.

The piezoelectric structures 131, 231, 331 of PMUT devices 20, 120, 220, 320 may comprise one or more rings, similarly to what shown in Figure 8, allowing the resonance frequency and therefore the desired optimal work frequency to be set, also on the basis of the desired application.

The support element 23, 123 and 323 may be missing and/or be replaced by a case of biocompatible material, such as polyether-ether-ketone (PEEK) or titanium, which completely surrounds the PMUT or CMUT device.

The micromachined ultrasonic transducer here described is also usable for communications and information exchange between a transmitting element and a receiving element.

In summary, exemplary embodiments of the present acoustic transducer may be summarized as follows:
Example 1. A micromachined ultrasonic transducer (120; 220; 320; 520; 520') comprising a die (121; 221; 321; 521) including semiconductor material, wherein:
   the die (121; 221; 321; 521) accommodates at least one ultrasonic cell (145; 245; 345),
   each ultrasonic cell (145; 245; 345; 545) includes a cavity (129; 229; 329; 529) extending inside the die (121; 221; 321) and a vibrating structure (127; 227; 327; 427; 527) overlying and vertically aligned with the cavity,
   wherein the vibrating structure (127; 227; 327; 427; 527) comprises an annular-shaped element (131; 231; 331; 431; 590),
   the micromachined ultrasonic transducer being configured to operate around the second axisymmetric vibration mode.
Example 2. The micromachined ultrasonic transducer according to the preceding example, wherein the vibrating structure (127; 227; 327; 427; 527) includes a membrane region (130; 230; 330; 530) and at least one electrode carried by the membrane region.
Example 2bis. The micromachined ultrasonic transducer according to the preceding example, wherein the cavity (129; 229; 329; 529) has a vertical central axis (S) and the vibrating structure (127; 227; 327; 427; 527) is concentric with the cavity.
Example 3. The micromachined ultrasonic transducer according to example 1 or 2 or 2bis, wherein the annular-shaped element comprises at least one piezoelectric region (36) of a piezoelectric structure (131; 231; 331; 431) including the at least one electrode and a second electrode, the at least one piezoelectric region being interposed between the at least one electrode and the second electrode.
Example 4. The micromachined ultrasonic transducer according to the preceding example, wherein the piezoelectric structure (431) comprises at least one further piezoelectric annular-shaped region (231B) having annular shape, concentric with the at least one piezoelectric region (231A).
Example 5. The micromachined ultrasonic transducer according to example 3 or 4, wherein the piezoelectric structure (131; 231; 331; 431) is formed by a stack (131; 231; 331) including a plurality of piezoelectric regions (436) each interposed between a respective first electrode (434) and a respective second electrode (435), with the first electrodes electrically coupled to each other and the second electrodes electrically coupled to each other.
Example 6. The micromachined ultrasonic transducer according to any of the preceding examples, comprising a support structure (122; 322; 522) mechanically and electrically coupled to the die (121; 321; 521), wherein:
   the support structure (122; 322; 522) comprises an electrical connection board (126; 326; 526) and a soft region (128; 328; 528);
   the electrical connection board (126; 326; 526) has an opening (124; 324; 524) accommodating the die; and
   the soft region extends on and adheres to the electrical connection board (126; 326; 526) and to the die (121; 321; 521), the soft region covering a main surface (121A; 321A; 521A) of the die delimiting the membrane region (130; 230; 330; 530) upwardly.
Example 7. The micromachined ultrasonic transducer according to the preceding example, wherein the soft region (128; 328; 528) has specific acoustic impedance comprised between 1 and 2 MRayl, density comprised between 0.8 and 2 g/cm³ and sound velocity comprised between 1000 and 2000 m/s.
Example 8. The micromachined ultrasonic transducer according to example 6 or 7, wherein the electrical connection board (126; 326; 526) is a printed circuit board wire-bonded to the die (121; 321; 521) with wires (125; 325) enclosed in the soft region (128; 328; 528).
Example 9. Micromachined ultrasonic transducer according to any of examples 6-8, wherein the opening (124; 324; 524) of the electrical connection board (126; 326; 526) is a through opening and the die (21; 321; 521) is suspended on a gap open to the outside.
Example 9bis. The micromachined ultrasonic transducer according to any of examples 6-8, wherein the support structure (122; 322) comprises a support element (123; 323) attached downwardly to the electrical connection board (126; 326) and forming a support wall spaced from the die and downwardly closing a gap (133) filled with air or with soft material such as silicone.
Example 10. The micromachined ultrasonic transducer according to any of examples 6-8, wherein the support structure (122; 322) comprises a support element (123; 323) downwardly attached to the die (121; 321) and downwardly closing the cavity (129; 229; 329).
Example 11. The micromachined ultrasonic transducer comprising a die (21; 221; 321; 521) including semiconductor material and a support structure (22; 322; 522) mechanically and electrically coupled to the die, wherein:
   the die (21; 221; 321; 521) accommodates at least one ultrasonic cell (45; 345; 545),
   the support structure (22; 322; 522) comprises an electrical connection board (26; 326; 526) and a soft region (28; 328; 528), and
   the electrical connection board (26; 326; 526) has an opening (24; 324; 524) accommodating the die,
   the soft region (28; 328; 528) extends on and adheres to the electrical connection board (26; 326; 526) and the die (21; 221; 321; 521), so that the die (21; 221; 321; 521) is suspended below the soft region (28; 128; 328; 528).
Example 12. The micromachined ultrasonic transducer according to the preceding example, of a piezoelectric type, wherein:
   each ultrasonic cell includes a cavity (29; 229; 329), a membrane region (30; 230; 330) and a piezoelectric structure (31; 231; 331), vertically aligned with each other, the cavity (29; 229; 329) extending in the die (21; 221; 321), the membrane region (30; 230; 330) formed by the die and delimited on one side by the cavity (29; 229; 329), and the piezoelectric structure (31; 231; 331) overlying the membrane region (30; 230; 330),
   the piezoelectric structure (31; 231; 331) comprises a stack including a lower electrode (34; 434), a piezoelectric region (36; 436) over the lower electrode, and an upper electrode (35; 435) overlying the piezoelectric region and having a disc-like or annular shape.
Example 13. The micromachined ultrasonic transducer according to example 11, of a capacitive type, wherein:
   each ultrasonic cell (545) includes a first electrode (590; 590'), a second electrode (591), a cavity (529) and a membrane region (530), vertically aligned with each other,
   the cavity (529) extends in the die (521),
   the membrane region (530) extends above the cavity (529),
   the first electrode (590; 590') is carried by the membrane region (530), and
   the second electrode (591) is arranged inside the cavity (529) and is capacitively coupled to the first electrode (590; 590').
Example 14. A system for wirelessly transferring energy comprising an energy transmission element and an energy reception element, wherein the energy transmission element is configured to generate ultrasonic waves and the energy reception element is configured to receive the ultrasonic waves generated, in use, by the transmission micromachined ultrasonic transducer, wherein at least one of the energy transmission element and the energy reception element comprises the micromachined ultrasonic transducer according to any of the preceding examples.
Example 15. A process of manufacturing a micromachined ultrasonic transducer, comprising:
   forming a die (21; 221; 321; 521) including semiconductor material, having a main surface (21A; 221A; 321A; 521A) and accommodating an ultrasonic cell (45; 345; 545);
   introducing the die (21; 221; 321; 521) into an opening (24; 324; 524) of an electrical connection board (26; 326; 526);
   electrically coupling the die (21; 221; 321; 521) to the electrical connection board (26; 326; 526); and
   forming a soft region (28; 328; 528) above the main surface (21A; 221A; 321A; 521A) of the die, the soft region adhering to the electrical connection board (26; 326; 526) and the die (21; 221; 321; 521) and suspending the die.

## Claims

1. A micromachined ultrasonic transducer (120; 220; 320; 520; 520') comprising a die (121; 221; 321; 521) including semiconductor material, wherein:
the die (121; 221; 321; 521) accommodates at least one ultrasonic cell (145; 245; 345),
each ultrasonic cell (145; 245; 345; 545) includes a cavity (129; 229; 329; 529) extending inside the die (121; 221; 321) and a vibrating structure (127; 227; 327; 427; 527) overlying and vertically aligned with the cavity,
wherein the vibrating structure (127; 227; 327; 427; 527) comprises an annular-shaped element (131; 231; 331; 431; 590),
the micromachined ultrasonic transducer being configured to operate around the second axisymmetric vibration mode.

2. The micromachined ultrasonic transducer according to the preceding claim, wherein the vibrating structure (127; 227; 327; 427; 527) includes a membrane region (130; 230; 330; 530) and at least one electrode carried by the membrane region.

3. The micromachined ultrasonic transducer according to claim 1 or 2, wherein the annular-shaped element comprises at least one piezoelectric region (36) of a piezoelectric structure (131; 231; 331; 431) including the at least one electrode and a second electrode, the at least one piezoelectric region being interposed between the at least one electrode and the second electrode.

4. The micromachined ultrasonic transducer according to the preceding claim, wherein the piezoelectric structure (431) comprises at least one further piezoelectric region (231B) having annular shape, concentric with the at least one piezoelectric region (231A).

5. The micromachined ultrasonic transducer according to claim 3 or 4, wherein the piezoelectric structure (131; 231; 331; 431) is formed by a stack (131; 231; 331) including a plurality of piezoelectric regions (436) each interposed between a respective first electrode (434) and a respective second electrode (435), with the first electrodes electrically coupled to each other and the second electrodes electrically coupled to each other.

6. The micromachined ultrasonic transducer according to any of the preceding claims, comprising a support structure (122; 322; 522) mechanically and electrically coupled to the die (121; 321; 521), wherein:
the support structure (122; 322; 522) comprises an electrical connection board (126; 326; 526) and a soft region (128; 328; 528);
the electrical connection board (126; 326; 526) has an opening (124; 324; 524) accommodating the die; and
the soft region extends on and adheres to the electrical connection board (126; 326; 526) and to the die (121; 321; 521), the soft region covering a main surface (121A; 321A; 521A) of the die delimiting the membrane region (130; 230; 330; 530) upwardly.

7. The micromachined ultrasonic transducer according to the preceding claim, wherein the soft region (128; 328; 528) has specific acoustic impedance comprised between 1 and 2 MRayl, density comprised between 0.8 and 2 g/cm³ and sound velocity comprised between 1000 and 2000 m/s.

8. The micromachined ultrasonic transducer according to claim 6 or 7, wherein the electrical connection board (126; 326; 526) is a printed circuit board wire-bonded to the die (121; 321; 521) with wires (125; 325) enclosed in the soft region (128; 328; 528).

9. The micromachined ultrasonic transducer according to any of claims 6-8, wherein the opening (124; 324; 524) of the electrical connection board (126; 326; 526) is a through opening and the die (21; 321; 521) is suspended on a gap that extends fully through the electrical connection board and is open to the outside or the support structure (122; 322) comprises a support element (123; 323) attached downwardly to the electrical connection board (126; 326) and forming a support wall spaced from the die and downwardly closing a gap (133) filled with air or with soft material such as silicone.

10. The micromachined ultrasonic transducer according to any of claims 6-8, wherein the support structure (122; 322) comprises a support element (123; 323) downwardly attached to the die (121; 321) and downwardly closing the cavity (129; 229; 329).

11. The micromachined ultrasonic transducer comprising a die (21; 221; 321; 521) including semiconductor material and a support structure (22; 322; 522) mechanically and electrically coupled to the die, wherein:
the die (21; 221; 321; 521) accommodates at least one ultrasonic cell (45; 345; 545),
the support structure (22; 322; 522) comprises an electrical connection board (26; 326; 526) and a soft region (28; 328; 528), and
the electrical connection board (26; 326; 526) has an opening (24; 324; 524) accommodating the die,
the soft region (28; 328; 528) extends on and adheres to the electrical connection board (26; 326; 526) and the die (21; 221; 321; 521), so that the die (21; 221; 321; 521) is suspended below the soft region (28; 328; 528).

12. The micromachined ultrasonic transducer according to the preceding claim, of a piezoelectric type, wherein:
each ultrasonic cell includes a cavity (29; 229; 329), a membrane region (30; 230; 330) and a piezoelectric structure (31; 231; 331), vertically aligned with each other, the cavity (29; 229; 329) extending in the die (21; 221; 321), the membrane region (30; 230; 330) formed by the die and delimited on one side by the cavity (29; 229; 329), and the piezoelectric structure (31; 231; 331) overlying the membrane region (30; 230; 330),
the piezoelectric structure (31; 231; 331) comprises a stack including a lower electrode (34; 434), a piezoelectric region (36; 436) arranged on the lower electrode, and an upper electrode (35; 435) overlying the piezoelectric region and having a disc-like or annular shape.

13. The micromachined ultrasonic transducer according to claim 11, of a capacitive type, wherein:
each ultrasonic cell (545) includes a first electrode (590; 590'), a second electrode (591), a cavity (529) and a membrane region (530), vertically aligned with each other,
the cavity (529) extends in the die (521),
the membrane region (530) extends above the cavity (529),
the first electrode (590; 590') is carried by the membrane region (530), and
the second electrode (591) is arranged inside the cavity (529) and is capacitively coupled to the first electrode (590; 590').

14. A system for wirelessly transferring energy comprising an energy transmission element and an energy reception element, wherein the energy transmission element is configured to generate ultrasonic waves and the energy reception element is configured to receive the ultrasonic waves generated, in use, by the transmission micromachined ultrasonic transducer, wherein at least one of the energy transmission element and the energy reception element comprises the micromachined ultrasonic transducer according to any of the preceding claims.

15. A process of manufacturing a micromachined ultrasonic transducer, comprising:
forming a die (21; 221; 321; 521) including semiconductor material, having a main surface (21A; 221A; 321A; 521A) and accommodating an ultrasonic cell (45; 345; 545) ;
introducing the die (21; 221; 321; 521) into an opening (24; 324; 524) of an electrical connection board (26; 326; 526) ;
electrically coupling the die (21; 221; 321; 521) to the electrical connection board (26; 326; 526); and
forming a soft region (28; 328; 528) above the main surface (21A; 221A; 321A; 521A) of the die, the soft region adhering to the electrical connection board (26; 326; 526) and the die (21; 221; 321; 521) and suspending the die.
